# EUROPEAN PATENT APPLICATION

(11) **EP 4 481 403 A1**
(43) Date of publication of application: **25.12.2024**
(21) Application number: 23181129.0
(22) Date of filing: 23.06.2023
(51) Int. Cl.: G01R 15/20, G01R 19/00

(54) **LEAD FRAME FOR SENSOR**

(71) Applicant: Melexis Technologies SA, 2022 Bevaix (CH)
(72) Inventor: PUT, Brecht, 3980 Tessenderlo (BE); VANGERVEN, Tim, 3980 Tessenderlo (BE); HOUIS, Simon, 2022 Bevaix (CH)
(74) Representative: Winger

(57) **Abstract**

A lead frame for a current sensor is provided. The frame includes a conductive piece with an average thickness, and a sensing zone for generating a signal detectable by a current sensing element when current flows through the lead frame. It also includes a routing zone outside the sensing zone for routing current towards the sensing zone. The routing zone comprises a region with the largest area having a predetermined average thickness. At least the sensing zone includes additional material disposed on the conductive piece so the total thickness of the sensing zone is thicker than the average thickness of said largest area.

## Description

### Field of the invention

The invention relates to the field of current sensing. More specifically it relates to measurement of currents using integrated current sensors, and to integrated current sensors and manufacture thereof.

### Background of the invention

Integrated current sensors are used in many applications where electric current needs to be monitored. These sensors redirect the current from their wires or tracks towards sensing elements, which pick up the signal. Since the sensing elements are packaged within the integrated current sensors, this means that the current to be sensed is applied to leads, usually called 'primary leads', which carry the current to be sensed through the integrated current sensor. Thus, the integrated current sensor needs to be able to withstand said currents to be sensed, and usual forms of noise in the current.

Traditional current sensors are capable of functioning at currents up to 50 A, and can accept peak currents of a few thousands of amperes, usually up to 20 kA. However, new products which handle high power are becoming more and more accessible to the public. Some recent applications of current sensors include electric vehicle applications, and energy harvesting devices such as solar panels and the like. Currents handled in these systems reach values above 50 A, and peak currents above 20 kA, for microseconds, even for tens of microseconds. Current sensors need to be reliable even if submitted to such currents. This can cause overheating of the conductors used for current redirection in existing current sensors, thermal damage, and even fusing.

It would be desirable to provide reliable current sensing capable of handling high currents while being integrated on other devices.

### Summary of the invention

It is an object of embodiments of the present invention to provide a lead frame for an integrated current sensor capable of carrying high current and withstand current surges without breaking or fusing. It is an object to provide a sensor including such lead frame for reliable and robust current measurement.

In a first aspect the present invention provides a lead frame for a current sensor. The lead frame comprises a conductive piece with an average thickness and a sensing zone for generating a signal detectable by a current sensing element when current flows through the lead frame. It also includes a routing zone outside the sensing zone for routing current towards the sensing zone. The routing zone comprises a region with a largest area having a predetermined average thickness. At least the sensing zone includes additional material disposed on the conductive piece so a total thickness of the sensing zone is thicker than the average thickness of said largest area.

It is an advantage of embodiments of the present invention that standard lead frames can be used or reused in current sensors for new high intensity applications. It is an advantage that a high current density can be provided with a heat generation lower than the necessary to fuse the lead frame.

In some embodiments, the lead frame comprises a necking on the sensing zone.

It is an advantage of embodiments that current density can increase locally for increasing magnetic signal while keeping heat dissipation low enough to avoid fusing or melting of components.

In some embodiments, the average thickness of the largest area of the routing zone is 250 micrometers.

It is an advantage of embodiments that a small amount of material is required. It is a further advantage that industry standard thickness can be used for a lead frame piece.

In some embodiments, the thickness of the sensing area is between 5% and 120% thicker than the average thickness of the conductive piece, for example between 10% and 80% thicker than the average thickness.

For example, the sensing area may be between 15 micrometers and 300 micrometers thicker than the average thickness. It is an advantage of embodiments that a local increase of thickness can be provided locally with no substantial change of form factor, so the LF can fit in standard sensor packages.

In some embodiments, the additional material disposed on the sensing zone also extends beyond the sensing zone into the routing zone. Still, the area with added material is smaller than the largest area of the routing zone which has the average thickness of the piece conductive piece.

It is an advantage of embodiments that the thicker area extending beyond the sensing zone improves die stability.

In some embodiments, the piece is a sheet that comprises two opposite planar faces, wherein the increase of thickness is provided on one or both faces of the sheet.

It is an advantage of embodiments that the thickness can be controlled accurately by providing additional material in both sides of the sheet.

In some embodiments, the additional material on a face of the sheet covers a first area and the additional material on the opposite face covers a second area, wherein the first area is larger than the second area.

It is an advantage of embodiments that a larger area can be provided on the side facing the sensing element for improving support thereof, and/or for saving plating material on the region where no support is required.

In some embodiments, the conductive piece is a conductive planar piece with constant and uniform thickness outside the sensing zone.

It is an advantage of embodiments of the present invention that a lead frame can be easily produced from a conductive, e.g. metal, plate.

In a further aspect, the present invention provides a current sensor comprising the lead frame of embodiments of the first aspect.

It is an advantage of embodiments of the present invention that a current sensor that withstands currents over 50 A and surge currents over 20 kA.

In a further aspect, the present invention provides a method of manufacturing a lead frame of embodiments of the first aspect, comprising providing a shaped conductive piece with an average thickness. Additional material is disposed on a zone being a sensing zone, so the total thickness of the sensing zone is thicker than the average thickness. The lead frame is thus divided on a sensing zone and a routing zone outside the sensing zone, wherein the routing zone has a largest area and an average thickness thinner than the total thickness of the sensing zone.

It is an advantage of embodiments of the present invention that a LF can be provided using a conductive piece (e.g. metal sheets) with thickness following industry standards.

In some embodiments, the additional material is provided by additive manufacturing techniques.

It is an advantage that highly tailored shapes can be provided for specific applications in a relatively simple way in a single manufacturing step.

In some embodiments, the additional material is provided by depositing conductive material on the lead frame, for example by vacuum deposition and/or electroplating. It is an advantage that multiple LFs can be produced in a single batch.

In some embodiments, the method further comprises providing a mask. It is an advantage that complex shapes can be applied.

In a further aspect, a method of providing a sensor is provided, comprising providing the lead frame in accordance with the previous aspect further comprising attaching a die to the lead frame and providing molding.

It is an advantage that the die does not need additional external support and can be connected to a different frame via wire bond or the like.

In some embodiments, the method further comprises providing an insulation layer between the lead frame and the die. It is an advantage that the electronics in the die can be protected from currents and surges through the lead frame.

In a further aspect, a packaged sensor is provided, comprising a lead frame in accordance with embodiments of the first aspect of the invention.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG 1 illustrates a top view of a current sensor known in the art.
FIG 2 illustrates a top view of a current sensor including a frame in accordance with embodiments of the present invention.
FIG 3 illustrates a cross section indicated in the top view of FIG 2, showing the sensing elements and the lead frame in the sensing zone.
FIG 4 illustrates a different cross section indicated in the top view of FIG 2, illustrating the routing and sensing zones of the lead frame.
FIG 5 illustrates a detail of the sensing zone of the lead frame and semiconductor die, wherein the lead frame and the SC die are attached to each other.
FIG 6 illustrates a top view of the lead frame of FIG 2 in accordance with embodiments of the present invention.
FIG 7 illustrates a top view of a lead frame in accordance with embodiments of the present invention. An attachment layer and SC die are shown also in superposition.
FIG 8 shows the cross section indicated in FIG 7.
FIG 9 shows a manufacture process flow for producing a lead frame, in accordance with embodiments of the present invention.
FIG 10 shows a manufacture process flow for producing a current sensor, in accordance with embodiments of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to "substrate", reference is made to an electronics platform, e.g. a semiconductor platform comprising sensing elements, usually known as 'semiconductor die' or simply SC die. The substrate comprises integrated circuitry, and it may be connected to sensing elements for sensing current, for example to one or more magnetic sensing elements. Sensing elements can be integrated in the same substrate, or stacked on top, or disposed next to the integrated circuitry.

Where in embodiments of the present invention reference is made to "lead frame" or LF, reference is made to a conductive structure designed to route signals from one contact (usually called 'lead') to another contact, usually to a contact in the substrate. Lead frames are part of semiconductor packages, usually including contacts which allow transfer of signals from the outside to the inside of the package. These contacts are specifically named 'pins' in the field. The primary LF in integrated sensors carries current to be sensed. Thus, it includes a sensing zone, which is disposed so that the sensing elements pick the signal. The primary LF also includes a routing zone, bringing the signal from the outside (from the pins) towards the sensing zone.

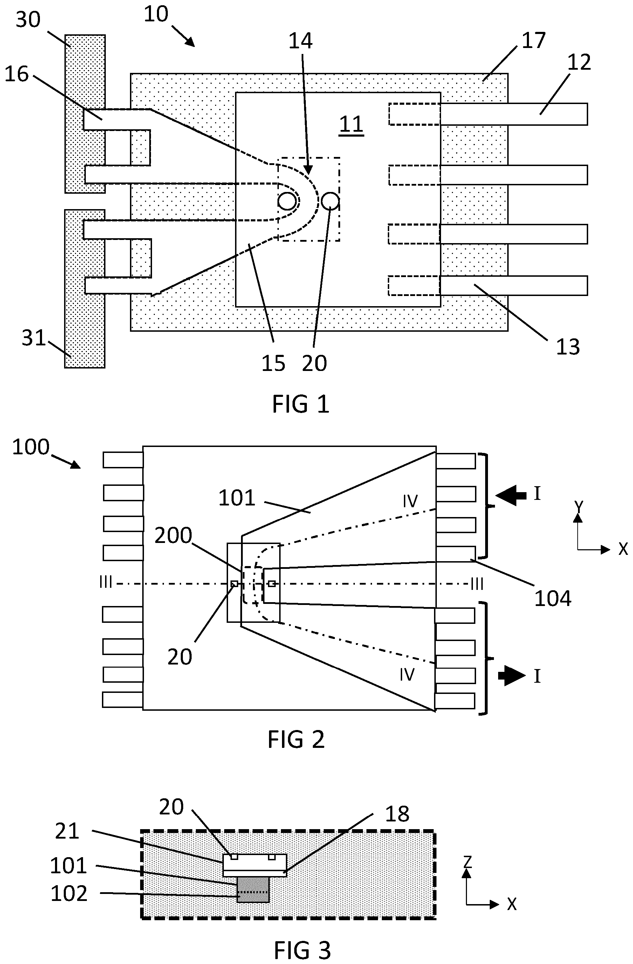

FIG 1 shows an integrated current sensor 10 provided as a packaged sensor, wherein the sensing element 20 is usually provided in a substrate 11, e.g. a semiconductor die. A current-carrying LF 15 ('primary LF') is connected to a first external conductor 30 via external pins 16 to introduce the current, or current to be tested, from that conductor into the package 17 of the packaged sensor 10. The primary LF routes the current to a zone 14 next to the sensing element (sensing zone), and then out of the package again via the further external conductor 31 connected in series to the pins, LF 15 and first conductor 30. The signals generated in the sensing element follow a path different from the primary LF. These signals are output through secondary leads to output pins 12 of the package. The secondary leads provide power supply to IC, and transmit the output signal (indicative of current) from the substrate to the output pins 12. The leads connected to the output pins 12 are usually included in a secondary LF 13 electrically connected to the substrate 11, for example by flip-chip connection or wire bonding.

In order to have a large signal, the current to be tested preferably flows close to the sensing element. In some embodiments, the substrate is supported by the primary LF, optionally by both the primary and the secondary LFs. In some embodiments, the substrate is not supported by the LFs, e.g. it may be located next to the LFs, optionally using a premolded device, etc. In some embodiments, the secondary LF may be the support of the substrate, not the primary LF.

The present invention relates mainly to primary LFs. In the following, when reference is made to LF, reference is made to primary LFs unless otherwise explicitly specified.

Traditional integrated current sensors have tolerances of approximately 50 A of stable currents. However, integrated current sensors need to be capable of withstanding increasingly higher current demands to enable their use in novel applications. These applications include battery management systems of electric vehicles, solar energy harvesting systems (in particular solar invertors), etc., which have requirements for integrated current sensors of 100 A for current carrying capability, and/or 20 kA for surge currents. However, current-carrying capability of standard LFs is limited.

Current capability is determined by the material and its geometry, which is on the other hand constricted by design, manufacture, and compactness requirements. Industry standards of LFs thickness usually do not comply with the requirements of these novel applications.

With thickness, it is understood as a dimension of the LF in a direction perpendicular to a plane formed by the routing and/or sensing region. This plane is the plane wherein the current to be tested flows. Thus, the thickness is perpendicular to the plane in which the current is flowing (hence the thickness perpendicular to the general direction of the current).

LFs with the standard thickness (250 microns) suffer thermal damage when submitted to such high currents and surges mentioned earlier. They may also suffer mechanical damage due to heating and/or coefficient of thermal expansion (CTE) mismatch with the surrounding material. Therefore, the industry is pushed towards thicker LFs on the order of 500 microns. This greatly increases the cost, due to a larger amount of raw material being used, non-standard and more complex tooling required in LF manufacturing and assembly, etc. Increasing the width of the LF requires larger spacing of the sensing elements, thus worsening the signal, and this option can make the sensor less compact.

In a first aspect, the present invention provides an LF formed by a conductive piece with an average thickness, which includes additional material disposed locally on a region of the conductive piece, being the sensing zone. The added material confers protection against high currents and surges. For example, the LF may have an average thickness with locally increased thickness at the sensing zone. This provides a more cost effective LF for integrated current sensors. The thickness increase is provided using for example electroplating, although other methods are also provided.

Total thickness is increased in the sensing zone of the LF, e.g. in the bridge, typically the zone closest to the sensing element. In some designs, the LF is configured so that the sensing zone is also the zone with the highest current density. This is the part that can potentially suffer the largest damage. Providing a larger thickness in this zone helps protecting the LF since the extra thickness on the sensing zone, which is usually configured to be the zone with largest current density, provides high thermal inertia and dissipation capability to the LF. Additionally, providing only a small portion of the lead frame with larger thickness allows saving material and allows using standard sheet thickness to provide LFs.

In embodiments of the present invention, the LF includes a narrowing or necking where the cross-section area is smallest. The necking reduces the area of passage of the current in the plane perpendicular to the thickness. The current is forced to pass through the necking. This increases the current density, so the stronger magnetic field generates a very high signal in the sensing element. Moreover, a necking allows sensing elements (e.g. magnetic sensing elements) to be placed close to each other, allowing a more compact design, and enabling a smaller substrate required to keep them.

FIG 2 shows a schematic top view of a current sensor 100 showing the current I direction into the LF 101 and into the sensor, and out of it, through the pins 104. LFs with such necking on the sensing zone benefit from a larger thickness, localized in the sensing zone 200 next to the sensing elements 20. The added material which provides the additional thickness is conductive, and it may be the same material as the rest of the LF, but it may be also different conductive material. The sensing elements may comprise magnetic field sensing elements which measure the magnetic field generated by the current through the LF 101, providing a signal dependent on said current. The magnetic field is produced by the current through the LF, also in the sensing zone 200. Since the sensing zone 200 next to the sensing elements has a local increase of the current, the field generated by that portion is large and the sensing elements are highly efficient in generating a signal based on the field.

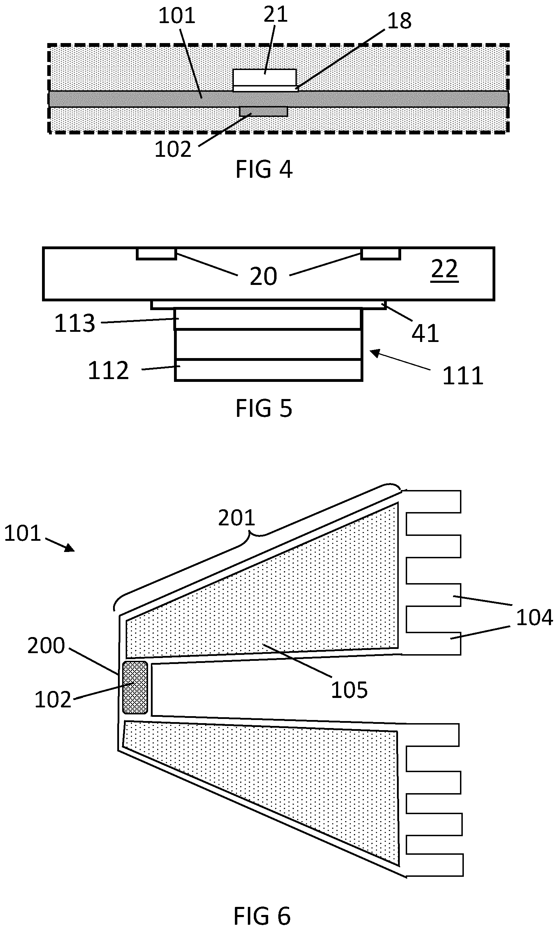

FIG 3 and FIG 4 show a cross section across the sensing elements on the substrate and across the length of the LF, respectively. The substrate 21 may include sensing elements. The substrate may be supported, optionally being attached, to the LF 101. A layer 18 of insulating material may be disposed between the LF 101 and the substrate 21. Said layer 18 may also be adhesive.

In some embodiments, the LF is a conductive planar piece or plate of uniform thickness outside the sensing area. This is shown in particular in FIG 4. The extra thickness is locally added in the z-direction to the sensing zone, e.g. to the narrow section wherein the sensing zone is defined. Since there is more material, the thermal inertia increases without having to provide larger width. The extra thickness does not significantly degrade the current-to-field conversion ratio (since it is not necessary to increase the width of the LF in the X direction). An advantage of the invention is that the maximum current capability is increased without changing (increasing) the width of the conductor, e.g. without removing or reducing the necking, which would require to increase the distance between the sensing elements to obtain a corresponding maximum signal. An integrated sensor with high sensitivity and high resilience against current surges can be obtained.

An increase of the thickness may be provided in any suitable way, for example an added layer 102 may be provided on one of the faces of the LF, for example in the face opposite to the substrate 21. One face is planar so the LF can support the substrate in a stable way, while the other face includes a 'bump' (added layer). The added layer 102 is shown in FIG 3 with a hatched line indicating the original thickness of the LF before providing the additional layer.

FIG 5 shows a similar cross section as in FIG 3 of an alternative LF 111 and a substrate being a semiconductor die 22, including magnetic sensing elements 20, for example magnetic sensing elements with an integrated circuit for processing signals generated by the sensing elements. In some embodiments, for example, the integrated circuit may be arranged to obtain a signal indicative of a difference between the two sensing signals.

The present invention is not limited to magnetic sensing elements integrated in the substrate. The sensing elements may be separate sensing elements connected to the substrate; for example, they may be stacked on the die. For example, sensing elements based on III-V semiconductor technology may be provided on the semiconductor die (based for example on silicon, the present invention not being limited thereto). For example, sensing elements based on magneto-resistive materials (xMR sensing) can also be stacked on the substrate.

The disposition of the sensing elements relative to the conductor can be optimised to maximise the signal. In some embodiments, the sensing elements are disposed at the periphery of the edges of the conductor, for example aligned to the edges. In some embodiments they may be slightly inside the periphery of the conductor, or slightly outside the periphery of the conductor. For instance, the centers of the sensing elements are located within a distance +/- 10%W or +/- 20%W from the edge of the conductor, where W is the width of the conductor.

FIG 5 shows a die-up configuration, where the active surface of the semiconductor die 22 (the surface of the die including the sensing elements 20) faces away the lead frame. However, the present invention is not limited thereto, and other configurations may be used, e.g. a flip-chip configuration, with the active surface of the substrate facing the lead frame.

The sensing element or elements may be chosen in accordance with the specific requirements of the sensor. In some embodiments, the magnetic sensing element has an axis of maximum sensitivity perpendicular to the substrate (e.g. horizontal Hall sensors). In some embodiments the magnetic field sensing element has an axis of maximum sensitivity parallel to the substrate, for example a vertical Hall plate, a magnetoresistive (MR) element, etc.

The die 22 and the LF 111 are both in contact with, and separated by, a layer of insulating material 41. In this case, the layer of insulating material is shown extending beyond the top area of the LF. This advantageously improves insulation since it increases the discharge path between the current-carrying LF and the substrate with the sensing elements. The layer of insulating material may cover the whole surface of the substrate facing the LF, thus improving further the insulation. In this LF 111, the thickness is increased by two additional layers 112, 113, one at each face of the LF. This overcomes some limitations of thickness inherent to some manufacturing process, e.g. deposition. Adding a layer at each side allows increasing the total equivalent thickness. Additionally, depositing a predetermined thickness only on one side takes usually longer than depositing half of the thickness on each side of the LF.

Regarding the added material, the additional thickness may be 5% or more of the average thickness of the LF, for example between 5% and 120%, for example between 10% and 80%, for example between 10% and 50%, for example between 20% and 40%, for example 30% of the frame thickness.

In some embodiments, for a lead frame thickness of 200 microns to 500 microns, for example around 250 microns, the thickness of the extra material may be for example 15 microns higher, for example 50 microns higher, for example 100 microns, e.g. 200 microns, for example up to 300 microns. In some embodiments, for example, 50 microns may be provided at each side, thus obtaining a thickness of the added material of 100 microns, or any other combination of added thickness.

Although the additional layer has been shown either on the face opposite to the substrate, or on both sides, the additional layer may be only on the face of the LF on the substrate side. Any of these options can be applied, depending on the particular sensor requirements. For example, a package can be kept flat at the bottom if the additional material is provided at the substrate side, in case the LF is exposed or partially exposed at the bottom side of the package (partially overmolded), as in the case of some types of the so-called 'flat no-leads' packages.

The material used for the added layer may be any conductive material, for example metal compatible with the material of the LF, e.g. the same material as the LF. For example, the material of the added layer may consist of or comprise Cu, Ti, Au, Al, Ag, Ni, Zn, Sn, or Cr, the list not being exhaustive. For example, materials that can easily be provided by plating can be used. The additional layer or layers may be provided on the LF so that there is a bond between the material of the additional layer(s) and the material LF, such as a chemical bond or the like, rather than merely gluing or otherwise adhering the layer to the LF. The transition between the layer and the LF may be gradual. The added layer may be a deposited layer, i.e. provided by deposition, e.g. plating, etc. This will be explained with reference to the method. The LF may include a deposited layer on one or both sides. The present invention is not limited to deposited layers, and layers added by other techniques such as additive manufacture (e.g. 3D printing) could be used.

FIG 6 shows a top view of the LF 101 of the sensor 100 in FIG 2. The LF includes a sensing zone 200, and a routing zone 201 which routes the current between the pins 104 and the sensing zone 200. The additional thickness may be limited to the sensing zone 200, or even just a portion thereof. The LF may have its largest area 105 outside the sensing zone 200, for example the routing zone 201 has the largest area, having an average predetermined thickness. This largest area is thinner than the sensing zone. In other words, the (average) predetermined thickness of the largest area 105 in the routing zone 201 is lower than the thickness in the sensing zone 200. For instance, the LF (in particular the routing zone) may have a uniform thickness outside the sensing zone 201, and the sensing zone 200 is thicker than this uniform thickness. The larger thickness is included in the sensing zone 200. It is limited to a relatively small area compared to the rest of the LF 101. The larger thickness is shown as a shaded area which may contain additional material, for example an additional layer 102 of material as shown in the cross section of FIG 3 and FIG 4, e.g. a deposited additional layer.

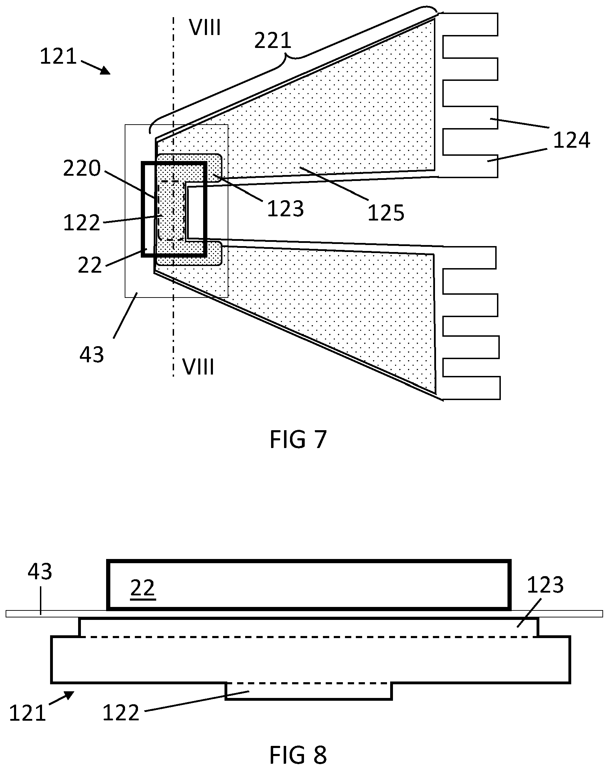

FIG 7 shows the top view of an LF 121 partially overlapped by an insulation layer 43 and a substrate 22 including sensing elements (not shown). The insulation layer 43 extends beyond the substrate 22 and over the LF 121, increasing the discharge path between the LF and said substrate. This is shown in FIG 8, corresponding to the cross section shown in FIG 7.

A top extended layer 123 is provided to increase the thickness of the LF at the sensing zone 200. In fact, the top extended layer 123 extends beyond the bridge of the sensing zone 220. It extends over the routing zone 221. This ensures stability of the overlapping substrate 22 being supported by the LF (and in particular by the top extended layer 123).

For example, the top layer may extend over the LF so that 50% of the substrate area, or 80% of the substrate area, or 100% of the substrate area is supported. The top layer may even extend beyond the area of the substrate 22, as shown in FIG 7 and FIG 8.

It is to be noted that, although the added top extended layer 123 extends over part of the LF outside of the sensing zone, thus into the routing zone 221, it is still a minor part of the total area of the LF. Thus, the thickness of the sensing zone 220 is still higher than the thickness in the largest area 125 with a predetermined average thickness (e.g. a uniform thickness).

FIG 8 also shows an optional layer 122 extending within the sensing zone 220 only, so it covers a smaller area than the top layer 123. Thus, the amount of conductive material used to produce the additional thickness can be reduced while still increasing the thickness at the sensing zone 220 and improving support. However, said optional layer in the face opposite to the substrate can extend also beyond the sensing zone 220, e.g. smaller, the same or larger area as the top layer 123. As mentioned earlier, as long as the sensing zone is thicker than the thickness of the largest area of the routing zone, the layer may be provided on the side of the LF facing the substrate, or on the opposite side, or on both, for example wherein the layer is provided on a larger area on the top side (adapted to provide flat support for the die) and a layer on the lower area (e.g. only the bridge) on the bottom side (saving plating material).

In some embodiments, the LF can be provided as a planar metallic foil (or in general, a thin sheet of conductive material) with uniform thickness while only a minor portion of its area may be thicker. This minor portion corresponds to the sensing zone 220, optionally also to a small surrounding portion (thus forming the top added layer 123). Thus, the LF can be protected from high currents and surges since the narrow section of the LF does not fuse or suffer thermal damage above 50 A. This is achieved with a minimal increase in the amount of material needed to produce it, and with no production costs that thicker sheets require.

In a second aspect, a method is provided to manufacture a lead frame in accordance with previous aspects of the present invention.

The method comprises providing a shaped piece (e.g. sheet) of material with an average predetermined thickness, and locally increase the thickness of the shaped piece of material on the area to be placed next to the sensing elements, thus improving dissipation of the piece when submitted to large currents and surges.

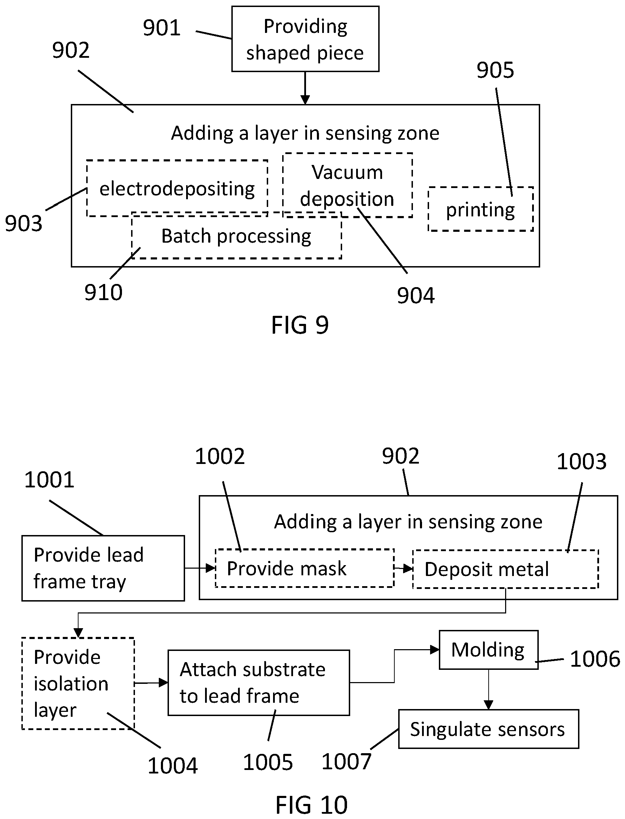

FIG 9 shows schematically a manufacture method, including optional steps. Providing 901 the shaped piece may comprise providing a metal sheet with uniform thickness. In some embodiments, it may also comprise providing a shaped piece including a necking. For example, a lead frame tray can be provided, where a plurality of LFs can be obtained.

Adding 902 a layer for increasing thickness can be done by deposition on the sensing zone. The transition between the layer and the LF is gradual, so the thickness of the LF can be considered to increase due to the added material of the layer. Adding the layer may comprise electrodepositing 903 material, e.g. conductive material.

This plating can be done in the plating lines at which silver plating is performed to enable wire-bonding. It would only require a change of the electrolyte. Thus, providing LF with additional thickness at the sensing zone can be done in the same industrial line as the assembly of the integrated sensor. Alternatively, vacuum-based deposition techniques 904 can be provided, for locally increasing the thickness. These may include atomic layer deposition (ALD), chemical vapor deposition (CVD), sputtering, evaporation, etc.

Electroforming/plating or sputtering methods allow batch processing 910, so several LFs can be simultaneously produced. These batch processes may include additional steps, such as for example providing a mask and depositing conducting material. The mask can be provided by photolithography techniques. A mask can be provided using a stencil, for example via stencil printing. The mask protects areas of the LF where no additional thickness is required. Thus, the mask may cover a large part of the LF, larger than the uncovered part, for example at least part of the routing zone.

Alternatively, a sequential process can be used, allowing fine-tuned individual processes. An example of these may include additive manufacturing techniques. For example, printing 905 such as 3D printing can be used to provide the additional thickness localized on the sensing zone (possibly extending partially over the routing zone).

In an aspect, the present invention provides manufacture of a sensor. The method comprises providing the LF following a method of the previous aspect of the present invention, and then providing a sensing die (including sensing elements) and arranging it so it can sense current through the LF. Optional steps can be performed, such as:
- providing electric connections between the substrate with sensing elements (e.g. integrated circuit) and a secondary LF
- providing insulation layer between the LF and the die

Then, molding can be provided for protecting the LFs and electronics.

A particular example as shown in FIG 10 may comprise providing 1001 a lead frame tray, which may include a plurality of LFs, and providing 1002 a mask on the tray. Then conductive material (usually metal) is deposited 1003, for example by plating, followed by removal of the mask thus providing extra thickness on the sensing zone by providing the additional layer thereon. This can be performed in industrial plating lines, typically used in the field of circuit assembly and packaging.

Optionally, an insulation layer can be provided 1004 between the LF and the substrate with the sensing elements. A substrate is provided, including the sensing elements, optionally also including electronics, contacts, etc. In preferred embodiments, the substrate is a die which is attached 1005 to the lead frame, the die being optionally electrically insulated from the lead frame. In some embodiments, the insulation layer may be an adhesive material with insulating properties, so providing 1004 the insulation layer can be done simultaneously with attaching 1005 the substrate to the LF. Hence, it is possible to combine electric insulation and attachment. However, these may be different steps, and an additional insulating layer may be deposited also on the LF and/or the substrate, followed by attachment, e.g. by an additional adhesive, of substrate and LF. In particular, the attachment is done so that the sensing element is adjacent to the sensing zone with the additional thickness.

The substrate is not only included in the device, but also signal output is provided, by connecting the substrate to a secondary LF, if needed. This can be done by flip-chip connection, wire bonding, etc. Then, molding 1006 can be provided. The manufacture of these steps as explained earlier may be done by batches, thus providing many sensors at once. After molding, singulation 1007 of the sensors may be provided.

This is just an example, and other processes may be followed, for example using additive manufacturing techniques.

In an aspect, the present invention provides a sensor including a lead frame in accordance with embodiments of the first aspect of the present invention.

Different packaging options can be applied to the manufacturing of the device. The lead frame can be obtained in accordance with embodiments of the second aspect. The sensor can be obtained in accordance with embodiments of the further aspect.

In some embodiments, the sensor is a packaged sensor. The packaged sensor may comprise a molded substrate and lead frames. The leads may extend out of the mold. The leads may not be exposed at a major surface of the package. For example, they may extend out forming connection pins 104 as shown in FIG 2. They may extend, for example, through lateral sides of the package. They may be optionally bent leads, such as dual in-line packages, or other types of packages (SOIC, TSSOP, etc.).

In other embodiments, the packaged sensor may be a flat package with exposed terminals. Optionally, the conductor may be exposed on a major surface of the package, for example at the bottom surface of the package. In some embodiments, the package is a no-lead package. The terminals may be exposed at the bottom side of the package. For example, the lead frame may be optionally exposed at the bottom side of the package. In such case the additional material may be provided on the LF on the side embedded by molding component, facing the substrate, so the bottom side can still be planar.

## Claims

1. A lead frame for a current sensor, the lead frame comprising a conductive piece with an average thickness and a sensing zone for generating a signal detectable by a current sensing element when current flows through the lead frame, and a routing zone outside the sensing zone for routing current towards the sensing zone, wherein the routing zone comprises a region with a largest area having a predetermined average thickness, wherein at least the sensing zone includes additional material disposed on the conductive piece so a total thickness of the sensing zone is thicker than the average thickness of said largest area.

2. The lead frame of the previous claim wherein the lead frame comprises a necking on the sensing zone.

3. The lead frame of any one of the previous claims wherein the average thickness of the largest area of the routing zone is 250 micrometers.

4. The lead frame of any one of the previous claims wherein the thickness of the sensing area is between 5% and 120% thicker than the average thickness of the conductive piece, for example between 10% and 80% thicker than the average thickness.

5. The lead frame of any one of the previous claims wherein the additional material is disposed on and beyond the sensing zone into the routing zone for an area smaller than the largest area of the routing zone.

6. The lead frame of any one of the previous claims wherein the piece is a sheet that comprises two opposite planar faces, wherein the additional material is provided on one or both faces of the sheet.

7. The lead frame of the previous claim wherein the additional material disposed on a face of the sheet covers a first area and the additional material disposed on the opposite face covers a second area, wherein the first area is larger than the second area.

8. The lead frame of any one of the previous claims wherein the conductive piece is a conductive planar piece with constant and uniform thickness outside the sensing zone.

9. Current sensor comprising the lead frame of any one of the previous claims.

10. A method of manufacturing a lead frame in accordance with claims 1 to 8, comprising providing a shaped conductive piece with an average thickness, and locally adding material on a zone being a sensing zone, so a total thickness of the sensing zone is thicker than the average thickness of the rest of the conductive piece, wherein the area of the conductive piece with the average thickness is larger than the sensing zone.

11. The method of the previous claim wherein locally adding material is provided by additive manufacturing techniques.

12. The method of claim 10 wherein locally adding material is provided by depositing conductive material on the lead frame, for example by vacuum deposition and/or electroplating.

13. The method of claim 12 further comprising providing a mask.

14. A method of providing a sensor comprising providing the lead frame in accordance with any one of the claims 9 to 13 further comprising attaching a die to the lead frame and providing molding.

15. The method of the previous claim further comprising providing an insulation layer between the lead frame and the die.
